# EUROPÄISCHE PATENTSCHRIFT

(11) **EP 2 718 916 B1**
(45) Veröffentlichungstag und Bekanntmachung des Hinweises auf die Patenterteilung: **10.08.2016**
(21) Anmeldenummer: 12728032.9
(22) Anmeldetag: 05.06.2012
(51) Int. Cl.: G08B 13/14, G08B 25/00, H01L 31/042

(54) **VERFAHREN ZUR DIEBSTAHLÜBERWACHUNG VON SOLARMODULEN UND SOLARANLAGE MIT EINER VIELZAHL VON SOLARMODULEN ZUR DURCHFÜHRUNG DES VERFAHRENS**
METHOD FOR THEFT-PREVENTION MONITORING OF SOLAR MODULES AND SOLAR INSTALLATION HAVING A MULTIPLICITY OF SOLAR MODULES FOR CARRYING OUT THE METHOD
PROCÉDÉ DE SURVEILLANCE DE MODULES SOLAIRES CONTRE LE VOL, AINSI QU'INSTALLATION SOLAIRE COMPORTANT UNE PLURALITÉ DE MODULES SOLAIRES POUR LA MISE EN OEUVRE DU PROCÉDÉ

(30) Priorität: 07.06.2011 DE 102011106221
(43) Veröffentlichungstag der Anmeldung: 16.04.2014
(73) Patentinhaber: Viamon GmbH, 67663 Kaiserslautern (DE)
(72) Erfinder: Strecke, Oliver, 67661 Kaiserslautern (DE)
(74) Vertreter: Kesselhut, Wolf
(86) Internationale Anmeldenummer: PCT/EP2012/002380
(87) Internationale Veröffentlichungsnummer: WO 2012/167909

(56) Entgegenhaltungen:
- EP-A2- 2 317 486
- DE-A1- 10 136 147
- DE-A1-102005 019 064

## Beschreibung

Die Erfindung betrifft ein Verfahren zur Diebstahlüberwachung von Solarmodulen sowie eine Solaranlage mit einer Vielzahl von Solarmodulen zur Durchführung des Verfahrens gemäß dem Oberbegriff von Anspruch 1 und 10.

Der Einsatz von photovoltaischen Solarmodulen stellt heutzutage einen bedeutenden Wachstumsmarkt dar, da die Erzeugung von elektrischem Strom aus Sonnenlicht mit Hilfe von Solarmodulen nicht nur umweltverträglich und Ressourcen schonend ist, sondern der elektrische Strom auch effizient transportiert und in nahezu jedwede beliebige andere Energieform umgewandelt werden kann. Hinzu kommt, dass Sonnenlicht in nahezu unbegrenzter Menge kostenlos zur Verfügung steht, was den Anreiz zum Bau von großen Solaranlagen mit einer Vielzahl von Solarmodulen, z.B. mit einigen 100 bis 10000 Modulen zusätzlich vergrößert.

Allerdings zeigt es sich in der letzen Zeit, dass die in derartigen Solaranlagen eingesetzten Solarmodule aufgrund ihres doch nicht unerheblichen Preises gerade bei Solaranlagen, die abgelegen von Ortschaften oder Städten installiert sind, oftmals in größerem Umfang gestohlen werden, um diese weiter zu veräußern oder in kleineren Anlagen selbst zu nutzen.

Die dadurch für die Eigentümer und Versicherer derartiger Anlagen entstehenden Schäden sind aus diesem Grunde in der letzten Zeit stark angestiegen, so dass von den Versicherern zunehmend höhere Versicherungsbeiträge verlangt oder Anlagen in kritischen Umgebungen überhaupt nicht mehr versichert werden, um dieser Entwicklung Rechnung zu tragen.

Obgleich aus dem Stand der Technik bereits Vorrichtungen und Verfahren bekannt sind, Solarmodule gegen die Gefahr eines Diebstahls abzusichern, sind die dafür benötigten Vorrichtungen vergleichsweise uneffektiv und teuer.

So ist es bekannt, die gesamten Anlagen mit einem Zaun zu umgeben, was ohne zusätzliche Überwachungseinrichtungen wie Kameras und Zugangswarneinrichtungen nur einen geringen Schutz darstellt, da derartige Zäune gerade bei abgelegenen Freilandanlagen von Dieben sehr leicht überkommen werden können. Der zusätzliche Einsatz von elektronischen Überwachungseinrichtungen wie Kontaktdrähten, die die Solaranlagen umgeben und unter Erzeugung eines Alarmsignal bei einem Kontakt reißen sowie auch Kameras, mit denen die Anlagen überwacht werden, besitzen den Nachteil, dass zusätzliches Wachpersonal erforderlich ist, welches den Alarm registrieren, bzw. die Monitore, auf denen die Kamerabilder übertragen werden, ständig überwachen muss. Dies erhöht die Betriebskosten derartiger Anlagen beträchtlich.

Hinzu kommt das Problem, dass in der Regel mehrere Anlagen von einer zentralen Alarmzentrale aus gleichzeitig überwacht werden, die bei Freilandanlagen üblicher Weise zentral mehrere Kilometer entfernt von den Anlagen angeordnet ist, so dass im Falle eines Diebstahls einige Zeit vergeht, bis das Wachpersonal zur betroffenen Anlage gelangt. Da bei einem tatsächlichen Diebstahl in der Regel zusätzlich auch die Ordnungskräfte alarmiert werden, vergeht meist zusätzliche Zeit, die den Dieben zur Verfügung steht, um die entwendeten Solarmodule abzutransportieren.

Aus der EP 2077588A2 ist es bekannt, die Solarmodule einer Solaranlage mit GPS und GSM Einheiten zu versehen, die es ermöglichen, ein Solarmodul per Funk zu überwachen.

Da jedes Solarmodul in der Regel eine eigene GSM-Einheit benötigt, die demgemäß auch jeweils mit einer eigenen SIM-Karte eines Mobilfunknetzbetreibers ausgerüstet werden muss, führt der Betrieb derartiger Solarmodule schon aufgrund der großen Menge an anzuschaffenden SIM-Karten sowie der beim Betrieb der GSM-Einheiten entstehenden Verbindungsgebühren zu erheblichen Betriebskosten. Hinzu kommt, dass die GSM-Einheiten aufgrund der großen Distanzen zwischen Sender und Empfängen zum Aufbau der Funkverbindung im Vergleich zu Nahbereichs-Funkverbindungen, wie z.B. Bluetooth-Verbindungen, viel elektrische Energie benötigen, die von den Solarmodulen bereit gestellt werden muss, was bei Tage und hoher Sonneneinstrahlung kein Problem darstellt, bei Nacht und an Tagen mit wenig oder nahezu keiner Sonneneinstrahlung, sowie auch bei Schnee, einen zusätzlichen Akkumulator mit einer ausreichenden Kapazität erfordert, was die Kosten abermals verteuert.

Die DE 101 36 147 A1 beschreibt eine Photovoltaikanlage mit mehreren Solarmodulen, die über eine als Nahbereichs-Datenkommunikationsnetzwerk dienende gemeinsame Sammelschiene miteinander verbunden sind, um Statusinformationen über die jeweiligen Solarmodule auszutauschen. Die Sammelschiene ist mit einem Wechselrichter mit integriertem Mikroprozessor verbunden, der als Master für die Kommunikation mit den DC-DC-Konvertern der Solarmodule dient, welche die von jedem Solarmodul erzeugte Gleichspannung auf eine höhere Spannung transformieren, die dem Wechselrichter anschließend zugeführt wird. Das Dokument gibt keinen Hinweis darauf, den einzelnen, über die Sammelschiene miteinander verbundenen Überwachungseinheiten die Funktion eines Masters, bzw. eines Slaves zu zuordnen und diese dazu zu nutzen, das Entfernen eines Moduls zu erkennen.

Die DE 10 2005 019 064 A1 beschreibt ein Verfahren zur Überwachung einer Gruppe von Objekten, wie bspw. einer Palette von Mobiltelefonen in einer Distributionskette, bei dem die Objekte mit Funkknoten versehen sind, die ein Nahbereichs-Datenkommunikationsnetzwerk bilden. Hierzu wird zumindest an einem der zu überwachenden Objekte ein Gateway-Knoten angeordnet, der sozusagen den Master bildet und beim Entfernen eines der Objekte aus der Gruppe auf Grund der unterbrochenen Übertragung im Nahbereichs-Datenkommunikationsnetzwerk ein entsprechendes Alarmsignal, z.B. über eine GSM-Verbindung, übermittelt. Die Schrift gibt keinen Hinweis darauf, dass einer der Funkknoten von vornerein die Funktion eines Masters besitzt, und diese Funktion von einem anderen Funkknoten in dem Augenblick übernommen wird, wenn der Gateway-Knoten aus dem Funknetzwerk entfernt wird.

Demgemäß ist es eine Aufgabe der vorliegenden Erfindung, ein Verfahren sowie eine Solaranlage mit einer Vielzahl von Solarmodulen zur Durchführung des Verfahrens zu schaffen, mit denen sich die Kosten für einen wirksamen Diebstahlschutz beim Betrieb derartiger Solaranlagen reduzieren lassen.

Diese Aufgabe wird erfindungsgemäß durch die Merkmale von Anspruch 1 und 10 gelöst.

Weitere Merkmale der Erfindung sind in den Unteransprüchen beschrieben.

Gemäß der Erfindung umfasst ein Verfahren zur Diebstahl-Überwachung von einzelnen Solarmodulen in einer Solaranlage, die eine Vielzahl von photovoltaischen Solarmodulen aufweist, beispielsweise mehrere einhundert Solarmodule, eine elektronische Überwachungseinheit, die Statusinformationen, wie beispielsweise die erzeugte elektrische Spannung eines oder mehrerer Module, die Temperatur der Module etc. über ein Fernbereichs-Datenkommunikationsnetzwerk an einen Server übermittelt. Die Übermittlung kann hierbei beispielsweise mittels einer bekannten GSM-Mobilfunk-Datenübertragungseinrichtung erfolgen, wie sie beispielsweise in Mobiltelefonen eingesetzt wird. Hierdurch lassen sich die Anlagen weitestgehend autark und ohne leitungsgebundene Netzwerkverbindungen auch an abgelegenen Standorten betreiben. Die elektronische Überwachungseinheit, die bevorzugt einen Mikrocontroller enthält, und auf die nachfolgend noch weiter eingegangen wird, sogt in diesem Falle dafür, dass beim Entfernen eines oder mehrerer Solarmodule aus der Solaranlage ein Warnsignal erzeugt wird, welches über das Fernbereichs-Datenkommunikationsnetzwerk an den Server übermittelt wird, der dieses z.B. an eine Überwachungszentrale weiterleitet, in der das Warnsignal z.B. als ein akustisches oder optisches Warnsignal über einen Lautsprecher und/oder einen Monitor ausgegeben wird.

Gemäß der Erfindung ist hierbei an einem ersten Solarmodul eine erste Überwachungseinheit und an einem zweiten Solarmodul eine zweite Überwachungseinheit angeordnet, die zum Austausch von Daten über ein weiteres Nahbereichs-Datenkommunikationsnetzwerk miteinander verbunden sind, beispielsweise über ein Bluetooth-Netzwerk, oder ein ZigBee oder ein W-Lahn-Netzwerk.

Die erste Überwachungseinheit am ersten Solarmodul besitzt hierbei erfindungsgemäß die Funktion eines Slaves im Nahbereichs-Datenkommunikationsnetzwerk, welcher lokale Statusinformationen, wie beispielsweise den eigenen Status, die eigene Netzwerkadresse, oder auch die gerade erzeugte Spannung und/oder die Temperatur des Solarmoduls etc. , an welchem die erste Überwachungseinheit angeordnet ist, über das Nahbereichs-Datenkommunikationsnetzwerk an die zweite Überwachungseinheit übersendet. Die zweite Überwachungseinheit übernimmt hierbei erfindungsgemäß die Funktion eines Masters im Nahbereichs-Datenkommunikationsnetzwerk, der die lokalen Statusinformationen des ersten Solarmoduls, sowie auch lokale Statusinformationen des zweiten Solarmoduls sammelt und kumuliert bevorzugt in vorgegebenen Zeitabständen, über das Fernbereichs- Datenkommunikationsnetzwerk an den Server übersendet.

Im Falle einer Unterbrechung des Datenaustauschs zwischen der ersten und zweiten Überwachungseinheit, die insbesondere im Falle eines Diebstahls des ersten Solarmoduls beim Entfernen desselben aus dem Nahbereichs-Datenkommunikationsnetzwerk eintritt, beispielsweise wenn das entfernte Solarmoduls in ein Transportfahrzeug verfrachtet und abtransportiert wird, übernimmt die erste Überwachungseinheit am entwendeten Modul die Funktion eines Masters, der in diesem Falle selbst ein Alarmsignal und/oder auch die Statusinformationen, die beispielsweise mit Hilfe eines der ersten Überwachungseinheit zugeordneten GPS-Moduls oder mittels eines GSM-Moduls durch Funkpeilung ermittelt werden können, über das Fernbereichs-Datenkommunikationsnetzwerk an den Server übersendet.

Die Erfindung besitzt den Vorteil, dass beim ordnungsgemäßen Betrieb der Solaranlage lediglich ein einziges GSM-Modul an der Master-Überwachungseinheit tätig ist und die Statusinformation in vorgegebenen Zeitabständen, beispielsweise alle ein bis zwei oder auch mehr Stunden an den Server übermittelt, wohingegen die als Slave dienenden Überwachungseinheiten, von denen bevorzugt mehrere innerhalb der Solaranlage vorgesehen sind, zwar eine GSM-Datenübertragungseinheit aufweisen können, jedoch diese solange inaktiv bleibt, bis die Nahbereichs-Datenkommunikationsverbindung aufgehoben wird und das aus dem Nahbereichs-Datenkommunikationsnetzwerk entfernte Solarmodul selbst die Funktion eines Masters übernimmt. Hierdurch lassen sich insbesondere bei sehr großen Solaranlagen mit einer Vielzahl von Solarmodulen, beispielsweise einhundert oder gar eintausend Solarmodulen, die Betriebskosten, die allein durch die GSM-Übertragung der Statusinformationen an den Server hervorgerufen werden, auf ein Minimum reduzieren. Ein weiterer Vorteil, der sich durch den Einsatz des erfindungsgemäßen Verfahrens ergibt, besteht darin, dass die Kosten zum Betrieb des Nahbereichs-Datenkommunikationsnetzwerks, das insbesondere ein Nahbereichs-Funknetzwerk ist, gegenüber dem Fernbereichsfunk über GSM oder Satellit oder dergleichen zum einen wenig Strom benötigt, und zum anderen keine Providergebühren verursacht, da es sich z.B. bei Bluetooth-Netzwerken oder auch bei W-LAN- oder ZigBee-Funknetzwerken um freie Funknetzwerke handelt.

Dadurch, dass jeder der bevorzugt größeren Anzahl von ersten Überwachungseinheiten, die beim ordnungsgemäßen Betrieb der Solaranlage als Slaves arbeiten, beim Ausfall der zweiten Master-Überwachungseinheit ebenfalls die Funktion eines Masters übernimmt, wird in vorteilhafter Weise eine Redundanz geschaffen, die eine erhöhte Sicherheit im Falle eines Ausfalls der sonst einzigen Master-Überwachungseinheit bietet.

Das erfindungsgemäße Vorsehen einer beim ordnungsgemäßen Betrieb einzigen zweiten Master-Überwachungseinheit bietet den weiteren Vorteil, dass die Statusinformationen der gesamten Solaranlage bereits vor ihrer Übersendung an den Server zentral durch die Master-Datenüberwachungseinheit miteinander verrechnet und auf redundante Daten hin optimiert werden können.

Nach einem weiteren, der Erfindung zugrunde liegenden Gedanken erfassen die erste Überwachungseinheit und/oder die zweite Überwachungseinheit nach einer Unterbrechung der Datenkommunikation über das Nahbereichs-Datenkommunikationsnetzwerk die eigene geographische Position, insbesondere über ein globales Positionierungssystem (GPS) oder ein Mobilfunknetzwerk (GSM) und übersenden diese selbständig als Statusinformation über das Fernbereichs-Datenkommunikationsnetzwerk an den Server. Hierbei wird die momentane Ortsposition der ersten Überwachungseinheit nach der Unterbrechung des Nahbereichs-Datenkommunikationsnetzwerks, d.h. die Position des jeweiligen Solarmoduls nach dem Entfernen aus der Solaranlage, bevorzugt fortlaufend in vorgegebenen Zeitabständen in einem Speicher der ersten Überwachungseinheit abgelegt, wobei die Position beispielsweise über ein in der ersten Überwachungseinheit ebenfalls enthaltenes GPS-Modul erhalten wird und/oder mit Hilfe der im Mobilfunknetz verfügbaren Positionierungsmethoden ermittelt werden kann, wenn beim Abtransport der entwendeten Solarmodule kurzfristig eine Mobilfunkverbindung hergestellt wird.

Hierdurch ergibt sich der Vorteil, dass die örtliche Position - und damit der Weg der entwendeten Solarmodule - auch in Regionen nachverfolgt werden kann, in denen aktiv kein Fernbereichs-Datenkommunikationsnetzwerk zur Verfügung steht. Ebenso kann in vorteilhafter Weise im Nachhinein anhand der in der zweiten Überwachungseinheit abgespeicherten Positionsdaten bewiesen werden, dass die entwendeten Photovoltaik-Module entlang einer bestimmten Strecke transportiert wurden, was in Hinblick auf eine kriminologische Nachweisbarkeit eines Diebstahls ebenfalls von Vorteil sein kann.

Um die erste Überwachungseinheit am entwendeten ersten Solarmodul während des Abtransport zuverlässig mit elektrischer Energie zu versorgen, ist es hierbei vorgesehen, die ersten und/oder zweiten Überwachungseinheiten jeweils mit Akkumulatoren auszurüsten, die die Elektronik der Überwachungseinheit mit Strom versorgt, wenn die Solarmodule selbst keine Energie erzeugen, beispielsweise bei Nacht, oder auch in abgeschlossenen, verdunkelten Transportfahrzeugen.

Bei der bevorzugten Ausführungsform der Erfindung ist es weiterhin vorgesehen, dass die erste Überwachungseinheit und bevorzugt auch die zweite Überwachungseinheit die eigene räumliche Lage und/oder die momentane Beschleunigung der Überwachungseinheit erfassen, beispielsweise über einen im Stand der Technik bekannten Beschleunigungs- oder auch Lagesensor. Die Überwachungseinheit, d.h. der darin enthaltene Mikrokontroller vergleicht in vorgegebenen Zeitabständen die aktuelle räumliche Lage und/oder Beschleunigung der Überwachungseinheit mit einem vorgegebenen Sollwert, d.h. der bisherigen Lage und/oder dem Neigungswinkel und/oder der üblichen Beschleunigung, welch letztere bei Windstille in der Regel bei 0 m/s² liegt. Wenn der oder die erfassten Werte dabei wiederholt vom vorgegebenen Wert abweichen, bzw. außerhalb eines vorgegebenen Toleranzbereichs liegen, setzt die Überwachungseinheit über das Nahbereichs-Datenkommunikationsnetzwerk ein Alarmsignal an den aktuellen Master ab, der dieses bevorzugt an den Server weiterleitet.

Die zuvor beschriebene Ausführungsform der Erfindung besitzt den Vorteil, dass der Energiebedarf der Überwachungseinheiten weiter reduziert werden kann, da die bekannten Lagesensoren, wie sie beispielsweise auch in Mobiltelefonen eingesetzt werden, einen verschwindend geringen Energiebedarf haben und somit eine Überwachung der Module über eine lange Zeit hinweg allein durch Akkumulatorbetrieb ermöglicht wird, wenn beispielsweise im Winter die Solarmodule über mehrere Tage oder Wochen hinweg mit Schnee bedeckt sind.

Ein weiterer Vorteil, der sich bei der zuletzt genannten Ausführungsform ergibt, besteht darin, dass das Entfernen eines Solarmoduls aus der Solaranlage selbst dann innerhalb des vorgesehen Zeitraums zu einem Alarmsignal führt, welches aktiv über das Nahbereichs-Datenkommunikationsnetzwerk an den aktiven Master übertragen wird, wenn die Zeitintervalle, in denen die Statusinformationen regelmäßig über das Nahbereichs-Datenkommunikationsnetzwerk an die Master-Überwachungseinheit übersandt werden, erheblich größer sind und beispielsweise mehrere Stunden betragen, um den Energieverbrauch der Anlage auf ein Mindestmaß zu verringern.

Nach einem weiteren der Erfindung zugrunde liegenden Gedanken umfasst die Solaranlage eine Vielzahl von ersten Solarmodulen, an denen jeweils eine erste Überwachungseinheit angeordnet ist, die zusammen mit weiteren Solarmodulen, die keine Überwachungseinheiten aufweisen, in einem Array von Solarmodulen angeordnet sind. Die ersten Überwachungseinheiten der ersten Vielzahl von Solarmodulen sind hierbei über das Nahbereichs-Datenkommunikationsnetzwerk mit einer einzigen zweiten Überwachungseinheit zum Datenaustausch von lokalen Statusinformationen und Alarmsignalen verbunden, die die Statusinformationen sämtlicher erster Solarmodule miteinander vergleicht und die Statusinformationen bevorzugt kumuliert und in aufbereiteter Form an den Server übersendet.

Bei dieser Ausführungsform der Erfindung ist das Solarmodul, an welchem sich die zweite Überwachungseinheit befindet, welche den Master im Nahbereichs-Datenkommunikationsnetzwerk bildet, bevorzugt im Bereich des Zentrums des Arrays von Solarmodulen angeordnet, und die Solarmodule, die mit den ersten Überwachungseinheiten versehen sind, befinden sich im Bereich der äußeren Ränder des Arrays.

Durch diese Ausführungsform der Erfindung ergibt sich der Vorteil, dass das Solarmodul, welches die zweite Master-Datenübertragungseinrichtung trägt, die beim Entfernen eines oder mehrerer der in den Randbereichen angeordneten ersten Datenüberwachungseinheiten das Alarmsignal an den Server übersendet, im Falle eines Diebstahls erst wesentlich später als die ersten randseitigen Solarmodule entfernt wird. Hierdurch wird die Zeitdauer, in der das Alarmsignal von der Master-Datenüberwachungseinheit fortlaufend an den Server übertragen wird, um einen Diebstahlalarm mitzuteilen, erheblich verlängert, und dem Wachpersonal sowie den Ordnungskräften steht entsprechend mehr Zeit zur Verfügung, entsprechende Maßnahmen zu ergreifen und den Ort des Diebstahls aufzusuchen.

Bei der zuvor beschriebenen Ausführungsform der Erfindung sind vorzugsweise lediglich 1% bis 30%, besonders bevorzugt lediglich 3% bis 5% aller Solarmodule der Solaranlage mit einer ersten Überwachungseinheit ausgerüstet, die zum Datenaustausch über das Nahbereichs-Datenkommunikationsnetzwerk miteinander verbunden sind. Hierdurch ergibt sich der Vorteil, dass die Kosten für den Diebstahlschutz gegenüber einer Solaranlage, bei der sämtliche Module mit einer entsprechenden ersten Überwachungseinheit, bzw. einer zweiten Überwachungseinheit ausgerüstet sind, noch einmal deutlich reduziert werden, ohne dass sich der Diebstahlschutz hierdurch nachteilig verschlechtert. Im Vergleich mit einem Zaun, der um die gesamte Anlage herum angebracht wird, oder einer Kamera, die die Anlage rund um die Uhr überwacht und deren Bilder von geeignetem Wachpersonal ständig ausgewertet werden müssen, ist es mit der zuvor beschriebenen Ausführungsform des erfindungsgemäßen Verfahrens möglich, durch verteilt angeordnete, teilweise schlafende Module die gesamte Anlage kosteneffektiv zu überwachen.

Nach einem weiteren der Erfindung zugrunde liegenden Gedanken werden die an den Solarmodulen angeordneten ersten und/oder zweiten Überwachungseinheiten wie bereits zuvor erwähnt, über einen zugeordneten Akkumulator nach dem Entfernen der Solarmodule mit elektrischer Energie versorgt, um das Alarmsignal und/oder die Statusinformationen zu einem oder auch zu mehreren vorgegebenen Zeitpunkten nach dem Entfernen des jeweiligen Solarmoduls über das Fernbereichs-Datenkommunikationsnetzwerk an den Server zu übersenden. Hierzu weisen die Solarmodule entsprechende GSM-Einheiten auf, welche nur in diesem Falle aktiviert werden und eine Mobilfunkverbindung über das Fernbereichs-Datenkommunikationsnetzwerk mit dem jeweiligen Server aufnehmen. Hierdurch ergibt sich der Vorteil, dass die Anlagen auch zu Nachtzeiten überwacht werden können, zu denen die Diebstahltätigkeit erfahrungsgemäß am größten ist. Zudem ist es ebenfalls möglich, die entwendeten Solarmodule auch über Wochen hinweg selbst dann noch zu orten, wenn die Module nach ihrer Demontage beispielsweise in einem LKW transportiert werden und selbst keine Energie mehr liefern.

Bei der zuletzt beschriebenen Ausführungsform der Erfindung besteht weiterhin die Möglichkeit, dass anhand einer dynamischen Anpassung der zeitlichen Abstände zwischen den vorgegebenen Zeitpunkten, zu denen ein Alarmsignal und/oder die örtlichen Positionsdaten von einem entwendeten Solarmodul über das in diesem Fall aktivierte Fernbereichs-Datenkommunikationsnetzwerk an den Server übersandt werden, dynamisch veränderbar sind, wodurch sich der Überwachungszeitraum auch bei vergleichsweise geringen Akkukapazitäten in vorteilhafter Weise noch zusätzlich verlängern lässt.

Schließlich kann es vorgesehen sein, dass die Solarmodule die von ihnen am Tage erzeugte elektrische Energie über einen Wechselrichter in ein elektrisches Leitungsnetz einspeisen, und dass die erste und zweite Überwachungseinheit bei Nacht im Falle von Schneefall, wenn die Solarmodule selbst keine Energie erzeugen, ihre zum Betrieb des Nahbereichs-Datenkommunikationsnetzwerks sowie auch des Fernbereichs-Datenkommunikationsnetzwerks benötigte elektrische Energie über den Wechselrichter aus dem Leitungsnetz beziehen, über den die elektrische Energie bei Sonneneinstrahlung in das elektrische Leitungsnetz eingespeist wird. Hierdurch wird sicher gestellt, dass die Akkumulatoren auch bei Nacht oder bei Schneefall stets immer vollständig aufgeladen sind, so dass im Falle eines Diebstahls die volle Kapazität der Akkumulatoren für Ortungszwecke zur Verfügung steht. Zudem wird durch den Betrieb des Nahbereichs-Datenkommunikationsnetzwerks, bzw. des Fembereichs-Datenkommunikationsnetzwerks die Anzahl an Lade/Entladezyklen der Akkumulatoren erheblich verringert, was zu einer vorteilhaften Erhöhung der Lebensdauer derselben führt. Hierbei hat es sich weiterhin gezeigt, dass aufgrund des vergleichsweise geringen elektrischen Energiebedarfs des Nahbereichs-Datenkommunikationsnetzwerks und auch der lediglich sporadischen Übersendung der kumulierten Statusinformationen durch die Master-Überwachungseinheit der Energiebedarf der erfindungsgemäßen Vorrichtung insgesamt sehr gering ist, so dass entsprechend günstige und kleinere Akkumulatoren mit einer geringen Kapazität ausreichend sind.

Nach einem weiteren der Erfindung zugrunde liegenden Gedanken werden die Daten über das Nahbereichs-Datenkommunikationsnetzwerk bevorzugt nicht durchgehend, sondern in vorgegeben Zeitabständen übertragen, die z.B. bei einer Übertragung pro Stunde liegen können. Ebenso werden bei der bevorzugten Ausführungsform der Erfindung zur Verringerung des Energiebedarfs sowie auch zur Reduzierung der mit der Datenübertragung über das Fernbereichs-Datenkommunikationsnetzwerk verbundenen Kosten die Datenübertragung an den Server ebenfalls in weiteren vorgegebenen Zeiträumen vorgenommen, z.B. alle 6 Stunden oder mehr. Durch die Übermittlung der Daten in vorgegebenen Zeitintervallen, d.h. in vorgegebenen Zeitschlitzen, ergibt sich neben einer deutlichen Reduzierung der Betriebskosten der weitere Vorteil, dass die zweite Master-Überwachungseinheit eine Störung, wie z.B. den Ausfall einer der ersten Überwachungseinheiten, auch daran erkennt, dass diese die Statusinformationen nicht innerhalb des vorgegebenen Zeitraums übersendet. Falls auch bei einer oder mehreren weiteren Überwachungseinheiten keine Übermittlung von Daten innerhalb des vorgegebenen Zeitraums erfolgt, so wird dies als Diebstahl oder als eine schwerwiegende Beschädigung erkannt und von der zweiten Überwachungseinheit ein entsprechendes Alarmsignal an den Server abgesetzt.

Schließlich kann es gemäß einem weiteren der Erfindung zugrunde liegenden Gedanken vorgesehen sein, dass die erste und/oder die zweite Überwachungseinheit die Modulspannung des zugeordneten Solarmoduls überwachen, und dass Alarmsignale und/oder Daten über einen erfassten Spannungsverlauf über das Fernbereichs-Datenkommunikationsnetzwerk übersandt werden, wenn sich der Verlauf der Modulspannung entsprechend einem vorgegebenen Muster verändert. Hierdurch eröffnet sich die Möglichkeit, dass neben einer Überwachung durch einen eingesetzten Beschleunigungs- oder Lagesensors, Unregelmäßigkeiten bei einem oder mehreren der ersten Solarmodule, die mit den ersten Überwachungseinheiten ausgerüstet sind, frühzeitig erkannt werden.

So kann das Alarmsignal beispielsweise dann ausgegeben werden, wenn sich die Modulspannung bei Sonneneinstrahlung innerhalb eines vorgegebenen Zeitraums, z.B. innerhalb von 10 Minuten, mehrmals sprunghaft verringert, was auf eine Demontage der Module hinweist. Ebenso ist es mit dieser Ausführungsform der Erfindung ebenfalls möglich, Störungen, wie z.B. lokale Verschmutzungen von Solarmodulen, frühzeitig zu erkennen.

Das erfindungsgemäße Verfahren wird nachfolgend am Beispiel einer Solaranlage mit einer Vielzahl von Solarmodulen zur Durchführung des Verfahrens unter Bezugnahme auf die Zeichnungen beschrieben. In den Zeichnungen zeigen:
- Fig. 1: eine schematische Darstellung einer erfmdungsgemäßen Solaranlage mit insgesamt 5 X 5 Solarmodulen, bei der die ersten Solarmodule mit den ersten Überwachungseinheiten an den vier Ecken und das Solarmodul mit der zweiten Überwachungseinheit im Zentrum des Arrays angeordnet sind,
- Fig. 2: eine schematische räumliche Darstellung einer an den Solarmodulen der Solaranlage von Fig. 1 eingesetzten Anschlussbox,
- Fig. 3: eine Aufsicht auf die geöffnete Anschlussbox mit eingesetzter Zusatzplatine,
- Fig. 4: eine schematische Darstellung der Unterseite einer Anschlussbox mit eingesetzter Zusatzplatine zur Verdeutlichung der Position des Ortungsmoduls, und
- Fig. 5: eine schematische räumliche Darstellung der Anschlussbox mit aufgesetzter Zusatzplatine von Fig. 3 mit geöffneten Gehäusedeckel.

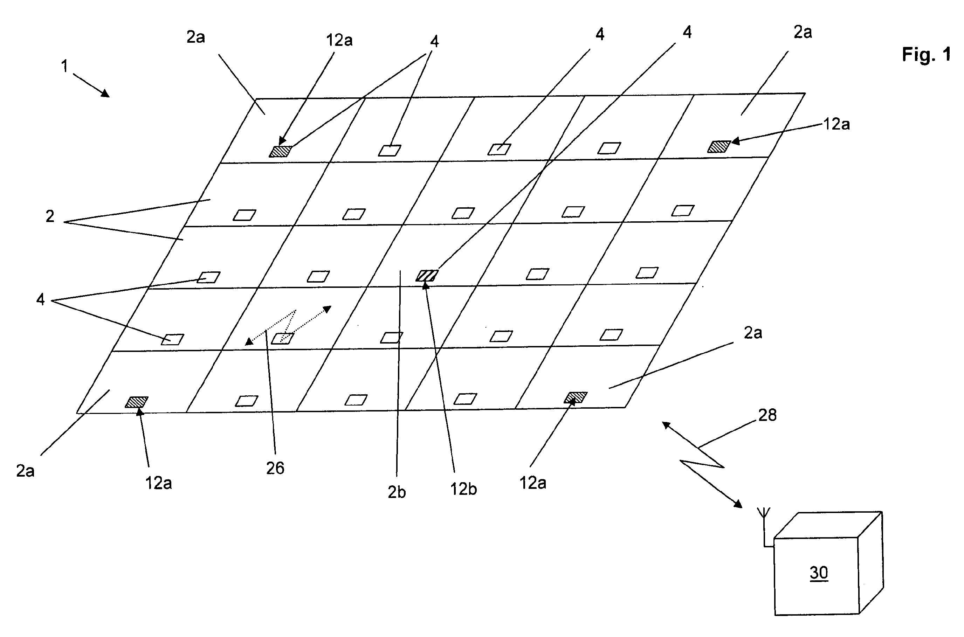

Wie in Figur 1 gezeigt ist, umfasst eine Solaranlage 1 eine Vielzahl von Solarmodulen 2, von denen jedes Solarmodul 2 eine verschließbare Anschlussbox 4 aufweist, die an der Unterseite des Moduls montiert ist und deren Innenraum 6 durch einen nicht näher gezeigten Deckel wasserdicht verschließbar ist.

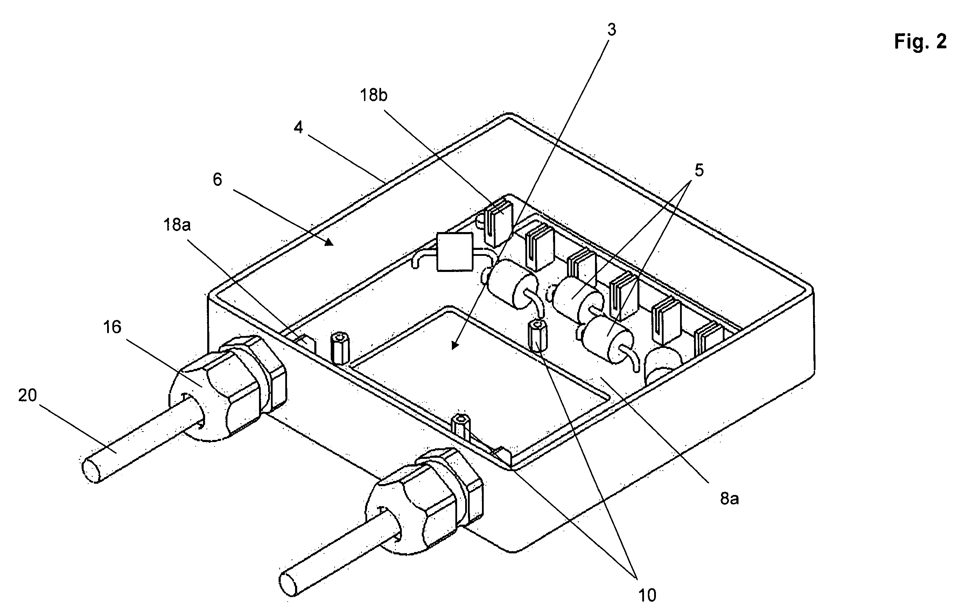

Wie der Darstellung von Figur 1 hierbei weiterhin entnommen werden kann, ist beispielhaft insgesamt vier Solarmodulen 2a, die nachfolgend als erste Solarmodule 2a bezeichnet werden, und die an den vier äußeren Ecken des gezeigten Arrays angeordnet sind, eine erste elektronische Überwachungseinheit 12a zugeordnet, die jeweils in der in den Figuren 2 bis 5 im Detail gezeigten Anschlussbox 4 als Zusatzplatine 8b aufgenommen ist, die auf eine in der Darstellung von Figur 2 gezeigte Basisplatine 8a im Huckepack-Verfahren aufgesteckt ist.

Gemäß der Darstellung von Figur 1 ist jedes der Solarmodule 2 der Solaranlage 1 mit einer von der äußeren Form her identischen Anschlussbox 4 versehen, welche zumindest die in Figur 2 gezeigte Basisplatine 8a enthält, die über Gehäusedurchführungen 16 und die Anschlussklemmen 18a mit den beiden elektrischen Zuleitungen 20 verbunden ist, über welche der elektrische Anschluss des jeweiligen Solarmoduls 2 an benachbarte Solarmodule oder auch an einen nicht dargestellten Wechselrichter erfolgt. Die Basisplatine 8a ist bei allen Solarmodulen 2 des Solaranlage 1 über eine Löt- oder Klemmverbindung mit nicht näher gezeigten Kontaktfähnchen des zugehörigen Solarmoduls 2 verbunden, die bevorzugt über Anschlussklemmen 18b bereit gestellt wird, die ebenfalls mit auf der Basisplatine 8a angeordnet sind.

Auf der Basisplatine 8a sind bevorzugt weiterhin Bypassdioden 5 vorgesehen, die einen Rückfluss des elektrischen Stroms im Falle eines Kurzschlusses in einem oder in mehreren photovoltaischen Elementen eines Solarmoduls 2 verhindern, um das photovoltaische Element in einem solchen Falle zu überbrücken.

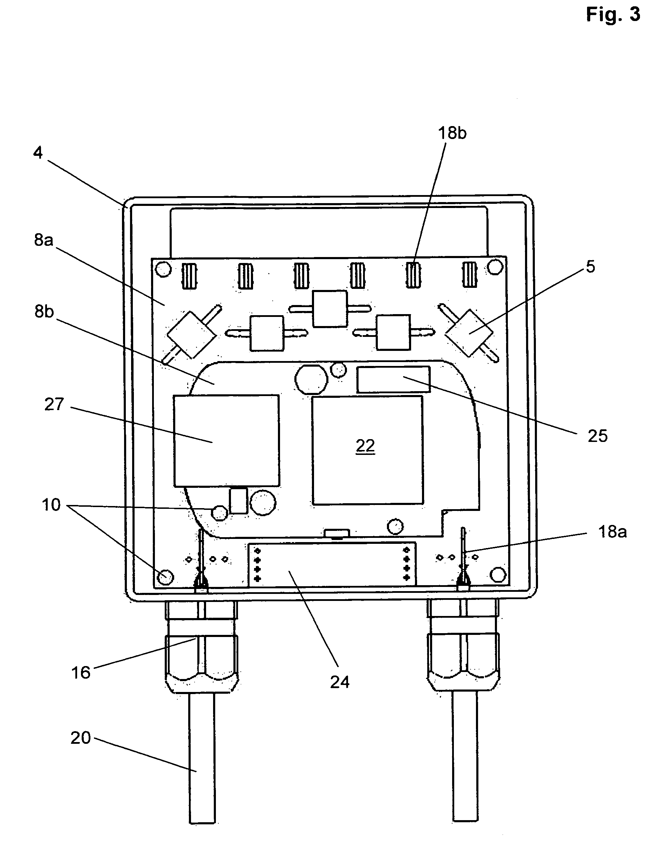

Wie der Darstellung von Fig. 2 und Fig. 3 weiterhin im Detail entnommen werden kann, sind auf der Basisplatine 8a ferner jeweils bevorzugt vier stiftartige Befestigungsmittel 10 angeordnet, über die die Zusatzplatine 8b nach dem Aufstecken auf die Basisplatine 8a mit dieser fest verbunden, insbesondere verschraubt werden kann.

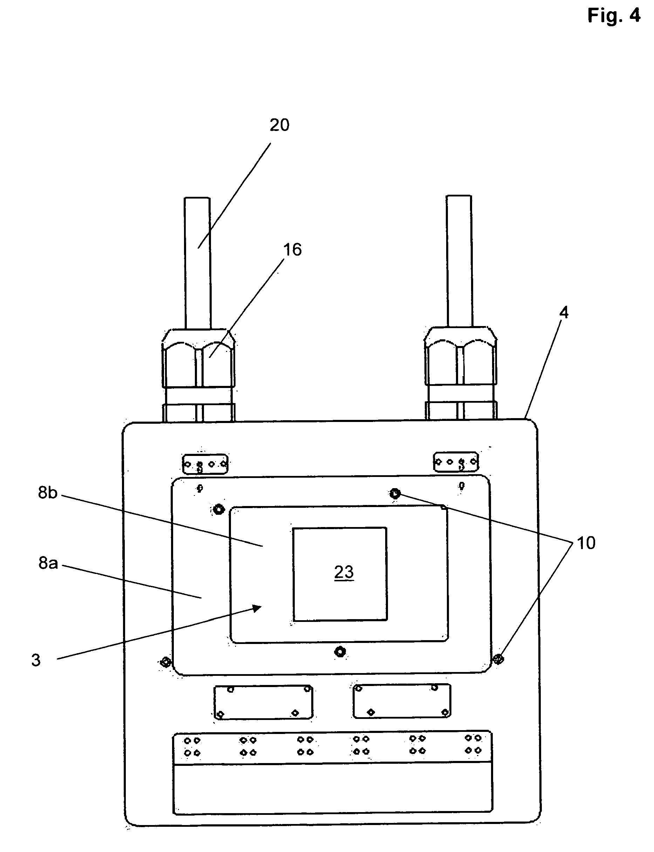

Die Zusatzplatine 8b enthält hierbei die eigentlichen elektronischen Bauteile der ersten elektronischen Überwachungseinheit 12a, sowie auch der bevorzugt identisch dazu aufgebauten zweiten elektronischen Überwachungseinheit 12b, die im Zentrum der Solaranlage 1 angeordnet ist. Die erste und zweite elektronische Überwachungseinheit 12a und 12b umfassen jeweils einen Mikrocontroller 22, ein Ortungsmodul 23, das bevorzugt ein GPS-Modul ist, welches zur Verbesserung der Funkverbindung zu einem Satelliten innerhalb einer in Fig. 4 gezeigten Öffnung 3 in der Basisplatine 8a aufgenommen ist, sowie ein mit dem Mikrocontroller 22 verbundenes und durch diesen angesteuertes Nahbereichs-Datenkommunikationsmodul in Form eines ZigBee-Moduls 25. Das Nahbereichs-Datenkommunikationsmodul 25 dient zur Übermittlung von Statusinformationen über das jeweilige erste Solarmodul 2a, welche über das Nahbereichs-Datenkommunikationsnetzwerk, welches in Fig. 1 durch den Pfeil 26 angedeutet ist, an die zentral angeordnete zweite Überwachungseinheit 12b übersandt werden. Bei einem ordnungsgemäßen Betrieb der Solaranlage 1 besitzt die zweite Überwachungseinheit 2b hierbei die Funktion eines Masters, und die ersten Überwachungseinheiten 12a übernehmen die Funktion eines Slaves innerhalb des Nahbereichs-Datenkommunikationsnetzwerks 26. Bei den Statusinformationen handelt es sich z.B. um die von einem nicht näher gezeigten Sensor auf der Zusatzplatine 8b erfasste Lage und/oder Beschleunigung der Zusatzplatine 8b einer Überwachungseinheit 12a sowie bevorzugt auch um die momentane Modulspannung oder Leistung des Solarmoduls 2a und weitere Parameter wie insbesondere die durch das Ortungsmodul 23 erfassten Ortskoordinaten.

Auf der Zusatzplatine 8b ist weiterhin ein vom Mikrocontroller 22 ansteuerbares Fernbereichs-Datenkommunikationsmodul in Form eines GSM-Moduls 27 mit zugeordnetem SIM-Kartenhalter angeordnet, welches in regelmäßigen Zeitabständen eine Funkverbindung über ein in Fig. 1 durch den Pfeil 28 angedeutetes Fernbereichs-Datenkommunikationsnetzwerk zu einem entfernten Server 30 erzeugt, welcher die lokalen Statusinformationen der vier ersten Solarmodule 2a erhält und verarbeitet. Die zweite elektronische Überwachungseinheit 12b unterscheidet sich dabei lediglich dadurch von der ersten elektronischen Überwachungseinheit 12a, dass sie die Funktion des Masters im Nahbereichs-Datenkommunikationsnetzwerk übernimmt, der das Fernbereichs-Datenkommunikationsmodul 27 aktiviert und zur Übermittlung der bevorzugt zuvor vom Mikrocontroller 22 der zweiten Überwachungseinheit 12b aufbereiteten Statusinformationen an den Server 30 veranlasst. Obgleich die Zusatzplatinen 8b aller vier gezeigten ersten elektronischen Überwachungseinheiten 12a bevorzugt ebenfalls ein Fernbereichs-Datenkommunikationsmodul 27 mit einer SIM-Karte besitzen, sind diese Module während des ordnungsgemäßen Betriebs der Anlage 1 nicht aktiviert, so dass in vorteilhafter Weise keine Übertragungsgebühren, bzw. Telefonkosten anfallen.

Erst wenn im Falle eines Diebstahls eines der vier ersten Solarmodule 2a aus der Anlage 1 entfernt wird und dadurch der Datenaustausch zwischen der bis dahin als Slave arbeitenden ersten Überwachungseinrichtung 12a dieses ersten Solarmoduls 2a und der als Master arbeitenden zweiten elektronischen Überwachungseinrichtung 12b des zentralen zweiten Solarmoduls 2b abreißt, übernimmt die erste elektronische Überwachungseinheit 12a auf dem entfernten Moduls 2a die Funktion eines Masters und aktiviert das Fernbereichs-Datenkommunikationsmodul 27 auf der Zusatzplatine 8b der ersten elektronischen Überwachungseinheit 12a. Sobald die erste elektronische Überwachungseinheit 12a das Fernbereichs-Datenkommunikationsmodul 27 aktiviert hat, übersendet der Mikrocontroller auf der Zusatzplatine 8b der entfernten ersten Datenübertragungseinheit 12a ein Alarmsignal sowie bevorzugt auch die aktuellen Positionsangaben des Ortungsmodul 23, welche er fortlaufend oder auch in vorgegebenen Zeitabständen von diesem erhält. Die zweite Überwachungseinheit 12b im Zentrum der Solaranlage 1 übersendet im Falle einer Unterbrechung der Nahbereichsfunkverbindung zu einem der mit ihr zum Datenaustausch gekoppelten ersten Überwachungseinheiten bevorzugt ebenfalls ein Alarmsignal an den zentralen Server 30, der dieses beispielsweise an eine Alarmzentrale weiterleitet und in akustischer oder visueller Form ausgibt.

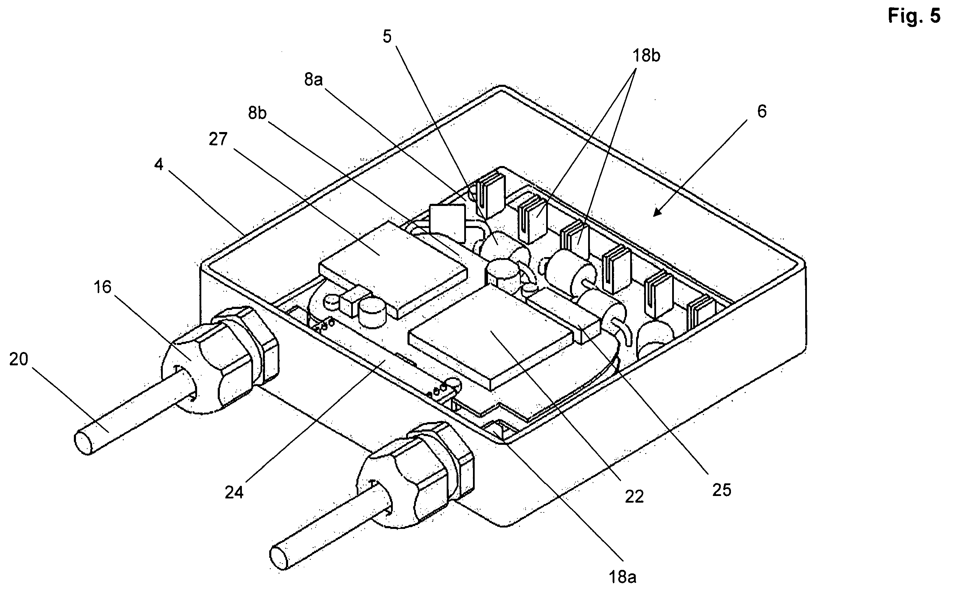

Wie der Darstellung der Figuren 3 und 5 weiterhin entnommen werden kann, ist auf der Zusatzplatine 8b weiterhin ein Netzteil 24 angeordnet, welches bevorzugt mit einem nicht näher gezeigten Akkumulator sowie über die Zuleitungen 20 auch mit einem ebenfalls nicht näher gezeigte Wechselrichter verbunden ist, über welchen die vom Solarmodul 2 erzeugte elektrische Energie in das Leitungsnetz eingespeist wird. Der Akkumulator, der bevorzugt über eine Ladeelektronik des Netzteils 24 geladen wird, versorgt im Falle eines Diebstahls die betreffende erste elektronische Überwachungseinheit 12a auf dem Modul 2a mit elektrischer Energie, so dass die Datenübertragung über das in diesem Falle als Master arbeitende Fernbereichs-Datenkommunikationsmoduls 27 auch bei Dunkelheit über mehrere Wochen aufrecht erhalten werden kann, um z.B. den Weg des entwendeten Solarmoduls anhand der vom Server 30 erhaltenen Positionsdaten zu verfolgen. Wenn gleichzeitig mehrere der entwendeten ersten Solarmodule 2a gemeinsam in einem Fahrzeug abtransportiert und zusammen in einem Gebäude gelagert werden, wird die Datenübertragung der Positionsdaten bevorzugt ausschließlich über die als Master arbeitende Überwachungseinheit 12a des zuerst aus dem Nahbereichs-Datenkommunikationsnetzwerk 26 entfernten Solarmoduls 2a vorgenommen, und die anderen ersten Überwachungseinheiten 12a der entfernten und zusammen gelagerten ersten Solarmodule 2a übernehmen in dem dann automatisch aufgebauten Nahbereichs-Datenkommunikationsnetzwerk 26 solange die Funktion eines Slaves, bis die Akkumulatorkapazität des Masters aufgrund der fortlaufenden Datenübertragung der Positionsdaten über das GSM-Modul 27 der Master Überwachungseinheit 12a erschöpft ist und die Fernbereichs-Funkverbindung unterbrochen wird. Nach dem Ausfall der Master - Überwachungseinheit 12a übernimmt dann eine der bisherigen Slave-Überwachungseinheiten 12a wiederum solange die Funktion des Masters, bis auch deren Akkumulatorkapazität erschöpft ist, usw.. Hierdurch ergibt sich insgesamt eine deutlich längere Betriebsdauer der Überwachungseinheiten 12a in den entwendeten ersten Modulen 2a, da die Energie zehrende GSM-Verbindung über das Fernbereichs-Datenkommunikationsnetzwerk 28 bevorzugt immer nur von einer Überwachungseinheit 12a aufgebaut wird, wohingegen die übrigen Überwachungseinheiten 12a an den entwendeten Modulen 2a lediglich Daten über das Nahbereichs-Datenkommunikationsnetzwerk 26 austauschen, was mit einem erheblich geringeren elektrischen Leistungsbedarf verbunden ist.

Der Mikrocontroller 22 und/oder das Fembereichs-Datenkommunikationsmodul 27 und/oder auch ein nicht näher gezeigtes Modul zur Überwachung der elektrischen Leistung des Solarmoduls 2 und/oder das Nahbereichsdatenkommunikationsmodul 25 sind bevorzugt als Module auf die Zusatzplatine 8b aufsteckbar, um die Funktionen der ersten und/oder zweiten elektronischen Überwachungseinheiten 12a, 12b erweitern zu können, oder um z:B. ein ZigBee-Nahbereichs-Datenkommunikationsmodul durch ein Bluetoothmodul oder ein W-LAN-Modul ersetzen zu können.

### Liste der Bezugszeichen

- 1: Solaranlage
- 2: Solarmodul
- 2a: erstes Solarmodul mit erste Überwachungseinheit
- 2b: zweites Solarmodul mit zweiter Überwachungseinheit
- 3: Öffnung in Basisplatine
- 4: Anschlussbox
- 5: Bypassdiode
- 6: Innenraum der Anschlussbox
- 8: Platineneinheit
- 8a: Basisplatine
- 8b: Zusatzplatine
- 10: Befestigungsmittel
- 12: erste elektronische Überwachungseinheit
- 14: zweite elektronische Überwachungseinheit
- 16: Gehäusedurchfiihrung/ Kabelverschraubung
- 18a: Anschlussklemme
- 18b: Anschlussklemme
- 20: elektrisches Leitungsnetz
- 22: Mikrocontroller
- 23: Ortungsmodul (GPS)
- 24: Netzteil
- 25: Nahbereichs-Datenkommunikationsmodul
- 26: Nahbereichs-Datenkommunikationsnetzwerk
- 27: Fernbereichs-Datenkommunikationsmodul
- 28: Fernbereichs-Datenkommunikationsnetzwerk
- 30: Server

## Patentansprüche

1. Verfahren zur Diebstahl-Überwachung von einzelnen Solarmodulen (2a, 2b) in einer Solaranlage (1) mit einer Vielzahl von Solarmodulen, wobei die Solaranlage (1) eine elektronische Überwachungseinheit (12a, 12b) aufweist, die Statusinformationen wie insbesondere die erzeugte Spannung und Temperatur der Module, über ein Fernbereichs-Datenkommunikationsnetzwerk (28) an einen Server (30) übermittelt, und beim Entfernen eines Solarmoduls (2a, 2b) aus der Solaranlage (1) ein Warnsignal erzeugt,
wobei eine erste Überwachungseinheit (12a) an einem ersten Solarmodul (2a) und eine zweite Überwachungseinheit (12b) an einem zweiten Solarmodul (2b) der Solaranlage (1) zum Datenaustausch über ein weiteres Nahbereichs-Daten-Kommunikationsnetzwerk (26) miteinander verbunden sind,
**dadurch gekennzeichnet,**
**dass** die erste Überwachungseinheit (12a) am ersten Solarmodul (2a) die Funktion eines Slaves im Nahbereichs-Datenkommunikationsnetzwerk (26) besitzt, welcher lokale Statusinformationen über das Nahbereichs-Datenkommunikationsnetzwerk an die zweite Überwachungseinheit (12b) übersendet, dass die zweite Überwachungseinheit (12b) die Funktion eines Masters im Nahbereichs-Datenkommunikationsnetzwerk (26) übernimmt, der die lokalen Statusinformationen des ersten Solarmoduls (2a) sowie lokale Statusinformationen des zweiten Solarmoduls (2b) kumuliert über das Fernbereichs-Datenkommunikations-netzwerk (28) an den Server (30) übersendet, und dass bei einer Unterbrechung des Datenaustauschs zwischen der ersten Überwachungseinheit (12a) und der zweiten Überwachungseinheit (12b) die erste Überwachungseinheit (12a) die Funktion eines Masters annimmt, der über das Fernbereichs-Datenkommunikationsnetzwerk (28) ein Alarmsignal und/oder Statusinformationen an den Server (30) übersendet.

2. Verfahren nach Anspruch 1,
**dadurch gekennzeichnet,**
**dass** die erste Überwachungseinheit (12) und/oder die zweite Überwachungseinheit (12b) nach einer Unterbrechung der Datenkommunikation über das Nahbereichs-Datenkommunikationsnetzwerk (26) die eigene geographische Position, insbesondere über ein globales Positionierungssystem (GPS) oder ein Mobilfunknetzwerk (GSM), erfasst und diese selbständig als Statusinformation über das Fembereichs-Datenkommunikationsnetzwerk (28) an den Server (30) übermittelt.

3. Verfahren nach Anspruch 1 oder 2,
**dadurch gekennzeichnet,**
**dass** die erste Überwachungseinheit (12a) die eigene räumliche Lage und/oder die momentane Beschleunigung der Überwachungseinheit (12a) erfasst und über das Nahbereichs-Datenkommunikationsnetzwerk (26) ein Alarmsignal übersendet, wenn diese innerhalb eines vorgegebenen Zeitraums wiederholt von einem vorgegebenen Sollwert abweicht.

4. Verfahren nach einem der vorhergehenden Ansprüche,
**dadurch gekennzeichnet,**
**dass** die Solaranlage (1) eine Vielzahl von ersten Solarmodulen (2a) mit einer jeweils daran angeordneten ersten Überwachungseinheit (12a) umfasst, die zusammen mit weiteren Solarmodulen (2) in einem Array von Solarmodulen angeordnet sind, und dass die Vielzahl von ersten Solarmodulen (2a) über das Nahbereichs-Datenkommunikationsnetzwerk (26) mit einer einzigen zweiten Überwachungseinheit (12b) zum Datenaustausch von lokalen Statusinformationen und Alarmsignalen verbunden ist, welche sich bevorzugt an einem Solarmodul (2b) im Bereich des Zentrums des Arrays von Solarmodulen (2, 2a, 2b) befindet.

5. Verfahren nach Anspruch 4,
**dadurch gekennzeichnet,**
**dass** lediglich 1 bis 30 %, bevorzugt 3 bis 5% aller Solarmodule (2, 2a, 2b) der Solaranlage (1) eine erste Überwachungseinheit (12a) besitzen, die zum Datenaustausch über das Nahbereichs-Datenkommunikationsnetzwerk (26) miteinander verbunden sind.

6. Verfahren nach einem der vorhergehenden Ansprüche,
**dadurch gekennzeichnet,**
**dass** die an einem Solarmodul (2a, 2b) angeordnete erste und/oder zweite Überwachungseinheit (12a, 12b) nach dem Entfernen des Solarmoduls (2a) aus der Solaranlage (1) durch das Solarmodul (2a, 2b) und/oder einen der Überwachungseinheit zugeordneten Akkumulator mit elektrischer Energie versorgt wird, um das Alarmsignal und/oder die Statusinformationen zu einem oder mehreren vorgegebenen Zeitpunkten nach dem Entfernen des Solarmoduls über das Fernbereichs-Datenkommunikations-netzwerk (28) an den Server (30) zu übersenden.

7. Verfahren nach einem der vorhergehenden Ansprüche,
**dadurch gekennzeichnet,**
**dass** die Solarmodule (2a, 2b) die von ihnen am Tage erzeugte elektrische Energie über einen Wechselrichter in ein elektrisches Leitungsnetz einspeisen, und dass die erste und zweite Überwachungseinheit (12a, 12b) bei Nacht ihre zum Betrieb des Nahbereichs-Datenkommunikationsnetzwerks (26) und des Fernbereichs-Datenkommunikations-netzwerks (28) benötigte elektrische Energie über den Wechselrichter aus dem Leitungsnetz beziehen.

8. Verfahren nach einem der vorhergehenden Ansprüche,
**dadurch gekennzeichnet,**
**dass** die erste und zweite Überwachungseinheit (12a, 12b) in vorgegebenen Zeiträumen, bevorzugt einmal pro Stunde, Daten über das Nahbereichs-Datenkommunikationsnetzwerk (26) übersenden, und/oder dass der Datenaustausch über das Fernbereichs-Datenkommunikationsnetzwerk (28) mit dem Server (30) in weiteren vorgegebenen Zeiträumen, insbesondere alle 6 Stunden, erfolgt.

9. Verfahren nach einem der vorhergehenden Ansprüche,
**dadurch gekennzeichnet,**
**dass** die erste und/oder die zweite Überwachungseinheit (12a, 12b) die Modulspannung des zugeordneten Solarmoduls (2a, 2b) überwachen, und dass das Alarmsignal und/oder Daten über einen erfassten Spannungsverlauf über das Fembereichs-Datenkommunikationsnetzwerk (28) an den Server (30) übersandt werden, wenn sich der Verlauf der Modulspannung entsprechend einem vorgegebenen Muster verändert.

10. Solaranlage (1) mit einer Vielzahl von Solarmodulen (2, 2a, 2b) insbesondere zur Durchführung des Verfahrens nach einem der vorhergehenden Ansprüche, wobei jedes Solarmodul (2, 2a, 2b) eine verschließbare Anschlussbox (4) aufweist, in welcher Anschlussklemmen (18a) zur elektrischen Verbindung mehrerer Solarmodule (2, 2a, 2b) der Solaranlage (1) untereinander aufgenommen sind,
wobei einem ersten Solarmodul (2a) eine erste Überwachungseinheit (12a) und einem zweiten Solarmodul (2b) eine zweite Überwachungseinheit (12b) zugeordnet ist,
**dadurch gekennzeichnet,**
**dass** die erste und zweite Überwachungseinheit (12a, 12b) im Wesentlichen identisch ausgebildet sind und jeweils eine elektrische Basisplatine (8a) sowie eine mit der Basisplatine (8a) verbindbare elektrische Zusatzplatine (8b) umfassen, die einen Mikrocontroller (22), ein mit diesem verbundenes und durch diesen angesteuertes Nahbereichs-Datenkommunikationsmodul (25), insbesondere W-LAN Modul, Blutooth-Modul oder ZigBee-Modul, sowie ein vom Mikrocontroller (22) ansteuerbares Fernbereichs-Datenkommunikationsmodul (27), insbesondere GSM-Modul umfasst, und dass die Basisplatine (8a) und/oder die Zusatzplatine (8b) eine der Form des Innenraums der Anschlussbox (4) angepassten Form besitzt und über mechanische Befestigungsmittel (10) im Innenraum der Anschlussbox arretierbar ist,
wobei die erste Überwachungseinheit (12a) am ersten Solarmodul (2a) die Funktion eines Slaves im Nahbereichs-Datenkommunikationsnetzwerk (26) besitzt, welcher Zum Übersenden von lokalen Statusinformationen über das Nahbereichs-Datenkommunikationsnetzwerk an die zweite Überwachungseinheit (12b) geeignet ist, wobei die zweite Überwachungseinheit (12b) geeignet ist, um die Funktion eines Masters im Nahbereichs-Datenkommunikationsnetzwerk (26) zu übernehmen, der geeignet ist, um die lokalen Statusinformationen des ersten Solarmoduls (2a) sowie lokale Statusinformationen des zweiten Solarmoduls (2b) kumuliert über das Fernbereichs-Datenkommunikationsnetzwerk (28) an den Server (30) zu übersenden, und wobei bei einer Unterbrechung des Datenaustauschs zwischen der ersten Überwachungseinheit (12a) und der zweiten Überwachungseinheit (12b) die erste Überwachungseinheit (12a) geeignet ist, um die Funktion eines Masters anzunehmen, der geeignet ist, um über das Fernbereichs-Datenkommunikationsnetzwerk (28) ein Alarmsignal und/oder Statusinformationen an den Server (30) zu übersenden.

11. Solaranlage nach Anspruch 10,
**dadurch gekennzeichnet,**
**dass** die elektrische Basisplatine (8a) über eine Löt- oder Klemmverbindung (18b) mit Kontaktfähnchen des zugehörigen Solarmoduls (2, 2a, 2b) verbunden ist, und dass der Mikrocontroller (22) und/oder das Fernbereichs-Datenkommunikationsmodul (27) und/oder ein Modul zur Überwachung der elektrischen Leistung des Solarmoduls und/oder das Nahbereichs-Datenkommunikationsmodul (25) auf die Basisplatine (8a) und/oder auf die Zusatzplatine (8b) aufsteckbar sind.

## Claims

1. A method for anti-theft monitoring of individual solar modules (2a, 2b) in a solar system (1) with a multiplicity of solar modules, wherein the solar system (1) has an electronic monitoring unit (12a, 12b) which transmits status information such as, in particular, the voltage generated and temperature of the modules, via a long-range data communication network (28) to a server (30), and which generates a warning signal if a solar module (2a, 2b) is removed from the solar system (1),wherein a first monitoring unit (12a) on a first solar module (2a) and a second monitoring unit (12b) on a second solar module 2b) of the solar system (1) are interconnected for the data exchange via a further short-range data communication network (26),
**characterized in that**
the first monitoring unit (12a) on the first solar module (2a) performs the function of a slave in the short-range data communication network (26), which slave transmits local status information via the short-range data communication network to the second monitoring unit (12b), that the second monitoring unit (12b) performs the function of a master in the short-range data communication network (26), which master transmits local status information of the first solar module (2a) and local status information of the second solar module (2b) in accumulated form via the long-range data communication network (28) to the server (30), and **in that** the first monitoring unit (12) performs the function of a master which transmits an alarm signal and/or status information to the server (30) when there is an interruption in the data exchange between the first monitoring unit (12a) and the second monitoring unit (12b).

2. The method according to claim 1,
**characterised**
**in that** the first monitoring unit (12) and/or the second monitoring unit (12b) after an interruption in the data communication via the short-range data communication network (26), records its own geographical position, in particular via a global positioning system (GPS) or a mobile network (GSM) and transmits this independently, as status information, via the long-range data communication network (28) to the server (30).

3. The method according to claim 1 or 2,
**characterised**
**in that** the first monitoring unit (12a) records its own geographical position and/or the current acceleration of the monitoring unit (12a) and transmits an alarm signal via the short-range data communication network (26) when it deviates from a predetermined setpoint within a predetermined period of time.

4. The method according to any one of the preceding claims,
**characterised**
**in that** the solar system (1) comprises a multiplicity of first solar modules (2a) with a first monitoring unit (12a) arranged on it, which unit, together with further solar modules (2), are arranged in an array of solar modules, and in that the multiplicity of first solar modules (2a) is connected by the short-range data communication network (26) to a single second monitoring unit (12b) for the data exchange of local status information and alarm signals, which second monitoring unit (12b) is preferably located on a solar module (2b) in the region of the centre of the array of solar modules (2, 2a, 2b).

5. The method according to claim 4,
**characterised**
**in that** only 1 to 30%, preferably 3 to 5% of all solar modules (2, 2a, 2b) of the solar system have a first monitoring unit (12a) which are interconnected via the short-range data communication network (26) for the data exchange.

6. The method according to any one of the preceding claims,
**characterised**
**in that** the first and/or second monitoring unit (12a, 12b) arranged on a solar module (2a, 2b) is supplied with electrical energy by the solar module (2a, 2b) and/or by a battery assigned to the monitoring unit, after the removal of the solar module (2a) from the solar system (1) in order to transmit the alarm signal and/or the status information at one or a plurality of predetermined times via the long-range data communication network (28) to the server (30) after the solar module is removed.

7. The method according to any one of the preceding claims,
**characterised**
**in that** the solar modules (2a, 2b) feed the electrical energy generated by them during the day via an inverter into an electrical supply network, and in that at night, the first and second monitoring unit (12a, 12b) obtain its electrical energy required to operate the short-range data communication network (26) and the long-range data communication network (28) from the supply network via the inverter.

8. The method according to any one of the preceding claims,
**characterised**
**in that** the first and second monitoring unit (12a, 12b) transmit data via the short-range data communication network (26) at predetermined times, preferably once per hour, and/or in that the data exchange via the long-range data communication network (28) with the server (30) takes place at further predetermined times, in particular every 6 hours.

9. The method according to any one of the preceding claims,
**characterised**
**in that** the first and/or the second monitoring unit (12a, 12b) monitor the module voltage of the assigned solar module (2a, 2b), and in that the alarm signal and/or data of a recorded voltage curve are transmitted to the server (30) via the long-range data communication network (28) if the curve of the module voltage changes according to a predetermined pattern.

10. A solar system (1) with a plurality of solar modules (2, 2a, 2b) in particular for implementing the method according to any one of the preceding claims, wherein each solar module (2, 2a, 2b) has a sealable connection box (4) which includes receiving terminals (18a) for the electrical interconnection of a plurality of solar modules (2, 2a, 2b) of the solar system (1), wherein a first monitoring unit (12a) is assigned to a first solar module (2a) and a second monitoring unit (12b) is assigned to a second solar module (2b),
**characterized in that**
the first and second monitoring unit (12a, 12b) are of an essentially identical design and each comprises an electrical basic board (8a) and an electrical additional board (8b) that can be connected to the basic board (8a), which additional board comprises a microcontroller (22), a short-range data communication module (25) connected to it and activated by it, in particular a W-LAN module, a Bluetooth module or ZigBee module, as well as a long-range data communication module (27) that can be activated by the microcontroller (22), in particular a GSM module, and **in that** the basic board (8a) and/or the additional board (8b) has a shape which is adapted to the shape of the interior of the connection box (4) and can be locked in the interior of the connection box by mechanical fixing means (10), wherein the first monitoring unit (12a) on the first solar module (2a) performs the function of a slave in the short-range data communication network (26), which slave is adapted for transmitting local status information via the short-range data communication network to the second monitoring unit (12b),
wherein the second monitoring unit (12b) is adapted to take over the function of a master in the short-range data communication network (26), which master is adapted to transmit the local status information of the first solar module (2a) and local status information of the second solar module (2b) in accumulated form via the long-range data communication network (28) to the server (30), and wherein the first monitoring unit (12a) is adapted to perform the function of a master which is adapted to transmit an alarm signal and/or status information to the server (30) via the long-range data communication network (28) when there is interruption in the data exchange between the first monitoring unit (12a) and the second monitoring unit (12b).

11. The solar system according to claim 10,
**characterised**
**in that** the electrical basic board (8a) is connected to contact tags of the associated solar module (2, 2a, 2b) by means of a soldered or clamp connection (18b), and in that the microcontroller (22) and/or the long-range data communication module (27) and/or a module for monitoring the electrical power of the solar module and/or the short-range data communication module (25) can be plugged into the basic board (8a) and/or the additional board (8b).

## Revendications

1. Procédé de surveillance de modules solaires isolés (2a, 2b) contre le vol dans une installation solaire (1) comprenant une multiplicité de modules solaires, dans lequel l'installation solaire (1) présente une unité de surveillance électronique (12a, 12b), qui transmet des informations d'état, comme en particulier la tension produite et la température des modules, à un serveur (30) par l'intermédiaire d'un réseau de communication de données à longue portée (28), et produit un signal d'alerte lors de l'enlèvement d'un module solaire (2a, 2b) hors de l'installation solaire (1), dans lequel une première unité de surveillance (12a) sur un premier module solaire (2a) et une deuxième unité de surveillance (12b) sur un deuxième module solaire (2b) de l'installation solaire (1) sont reliées l'une à l'autre pour l'échange de données par l'intermédiaire d'un autre réseau de communication de données local (26), **caractérisé en ce que** la première unité de surveillance (12a) sur le premier module solaire (2a) possède la fonction d'un esclave dans le réseau de communication de données local (26), qui transmet des informations d'état locales à la deuxième unité de surveillance (12b) par l'intermédiaire du réseau de communication de données local (26), **en ce que** la deuxième unité de surveillance (12b) assure la fonction d'un maître dans le réseau de communication de données local (26), qui transmet les informations d'état locales du premier module solaire (2a) ainsi que des informations d'état locales du deuxième module solaire (2b) sous forme cumulée au serveur (30) par l'intermédiaire du réseau de communication de données à longue portée (28), et **en ce que**, en cas d'interruption de l'échange de données entre la première unité de surveillance (12a) et la deuxième unité de surveillance (12b), la première unité de surveillance (12a) reprend la fonction d'un maître, qui transmet un signal d'alarme et/ou des informations d'état au serveur (30) par l'intermédiaire du réseau de communication de données à longue portée (28).

2. Procédé selon la revendication 1, **caractérisé en ce que** la première unité de surveillance (12) et/ou la deuxième unité de surveillance (12b) détecte, après une interruption de la communication de données par l'intermédiaire du réseau de communication de données local (26), sa position propre, en particulier par l'intermédiaire d'un système de positionnement global (GPS) ou d'un réseau téléphonique mobile (GSM), et la transmet automatiquement au serveur (30) comme information d'état par l'intermédiaire du réseau de communication de données à longue portée (28).

3. Procédé selon la revendication 1 ou 2, **caractérisé en ce que** la première unité de surveillance (12a) détecte sa position spatiale propre et/ou l'accélération instantanée de l'unité de surveillance (12a) et transmet un signal d'alarme par l'intermédiaire du réseau de communication de données local (26), lorsque celle-ci s'écarte d'une valeur de seuil prédéterminée de manière répétée à l'intérieur d'un laps de temps prédéterminé.

4. Procédé selon l'une quelconque des revendications précédentes, **caractérisé en ce que** l'installation solaire (1) comprend une multiplicité de premiers modules solaires (2a) avec une première unité de surveillance (12a) agencée respectivement à ceux-ci, qui sont disposés avec d'autres modules solaires (2) en un réseau de modules solaires, et **en ce que** la multiplicité de premiers modules solaires (2a) est reliée à une deuxième installation de surveillance isolée (12b) par l'intermédiaire du réseau de communication de données local (26) en vue de l'échange de données d'informations d'état locales et de signaux d'alarme, laquelle se trouve de préférence sur un module solaire (2b) dans la région du centre du réseau de modules solaires (2, 2a, 2b).

5. Procédé selon la revendication 4, **caractérisé en ce que** seuls 1 à 30 %, de préférence 3 à 5 % de tous les modules solaires (2, 2a, 2b) de l'installation solaire (1) possèdent une première unité de surveillance (12a), qui sont reliées l'une à l'autre en vue de l'échange de données par l'intermédiaire du réseau de communication de données local (26).

6. Procédé selon l'une quelconque des revendications précédentes, **caractérisé en ce que** la première et/ou la deuxième unité de surveillance (12a, 12b) disposée sur un module solaire (2a, 2b) est alimentée en énergie électrique par le module solaire (2a, 2b) et/ou par un accumulateur associé à l'unité de surveillance après l'enlèvement du module solaire (2a) hors de l'installation solaire (1), afin de transmettre le signal d'alarme et/ou les informations d'état au serveur (30) à un ou plusieurs instant(s) prédéterminé(s) après l'enlèvement du module solaire par l'intermédiaire du réseau de communication de données à longue portée (28).

7. Procédé selon l'une quelconque des revendications précédentes, **caractérisé en ce que** les modules solaires (2a, 2b) injectent l'énergie électrique produite par eux pendant la journée dans un réseau de puissance électrique par l'intermédiaire d'un onduleur, et **en ce que** la première et la deuxième unités de surveillance (12a, 12b) prélèvent la nuit du réseau de puissance, par l'intermédiaire de l'onduleur, l'énergie électrique nécessaire au fonctionnement du réseau de communication de données local (26) et du réseau de communication de données à longue portée (28).

8. Procédé selon l'une quelconque des revendications précédentes, **caractérisé en ce que** la première et la deuxième unités de surveillance (12a, 12b) transmettent, à des intervalles de temps prédéterminés, de préférence une fois par heure, des données par l'intermédiaire du réseau de communication de données local (26), et/ou **en ce que** l'échange de données avec le serveur (30) est effectué à d'autres intervalles de temps prédéterminés, en particulier toutes les 6 heures, par l'intermédiaire du réseau de communication de données à longue portée (28).

9. Procédé selon l'une quelconque des revendications précédentes, **caractérisé en ce que** la première et/ou la deuxième unité de surveillance (12a, 12b) surveillent la tension de module du module solaire associé (2a, 2b), et **en ce que** le signal d'alarme et/ou des données concernant une allure de tension détectée est envoyé/sont envoyées au serveur (30) par l'intermédiaire du réseau de communication de données à longue portée (28), lorsque l'allure de la tension de module varie suivant un modèle prédéterminé.

10. Installation solaire (1) avec une multiplicité de modules solaires (2, 2a, 2b), en particulier pour la mise en oeuvre du procédé selon l'une quelconque des revendications précédentes, dans laquelle chaque module solaire (2, 2a, 2b) présente une boîte de raccordement refermable (4), dans laquelle des bornes de raccordement (18a) sont logées l'une en dessous de l'autre pour le raccordement électrique de plusieurs modules solaires (2, 2a, 2b) de l'installation solaire (1), dans laquelle une première unité de surveillance (12a) est associée à un premier module solaire (2a) et une deuxième unité de surveillance (12b) est associée à un deuxième module solaire (2b), **caractérisée en ce que** la première et la deuxième unités de surveillance (12a, 12b) sont essentiellement identiques et comprennent respectivement une platine électrique de base (8a) ainsi qu'une platine électrique auxiliaire (8b) pouvant être électriquement reliée à la platine de base (8a), qui comprend un microcontrôleur (22), un module de communication de données local (25) relié à celui-ci et commandé par celui-ci, en particulier un module W-LAN, un module Bluetooth ou un module ZigBee, ainsi qu'un module de communication de données à longue portée (27) pouvant être commandé par le microcontrôleur (22), en particulier un module GSM, et **en ce que** la platine de base (8a) et/ou la platine auxiliaire (8b) possède(nt) une forme adaptée à la forme de l'espace intérieur de la boîte de raccordement (4) et peut/peuvent être calée(s) dans l'espace intérieur de la boîte de raccordement (4) par des moyens de fixation mécaniques, dans laquelle la première unité de surveillance (12a) sur le premier module solaire (2a) possède la fonction d'un esclave dans le réseau de communication de données local (26), qui convient pour la transmission d'informations d'état locales à la deuxième unité de surveillance (12b) par l'intermédiaire du réseau de communication de données local, dans laquelle la deuxième unité de surveillance (12b) convient pour assurer la fonction d'un maître dans le réseau de communication de données local (26), qui convient pour transmettre au serveur (30) sous forme cumulée les informations d'état locales du premier module solaire (2a) ainsi que des informations d'état locales du deuxième module solaire (2b) par l'intermédiaire du réseau de communication de données à longue portée (28), et dans laquelle, en cas d'interruption de l'échange de données entre la première unité de surveillance (12a) et la deuxième unité de surveillance (12b), la première unité de surveillance (12a) convient pour reprendre la fonction d'un maître, qui convient pour transmettre un signal d'alarme et/ou des informations d'état au serveur (30) par l'intermédiaire du réseau de communication de données à longue portée (28).

11. Installation solaire selon la revendication 10, **caractérisée en ce que** la platine électrique de base (8a) est raccordée à des lamelles de contact du module solaire correspondant (2, 2a, 2b) par brasage ou par des raccords à bornes (18b), et **en ce que** le microcontrôleur (22) et/ou le module de communication de données à longue portée (27) et/ou un module pour la surveillance de la puissance électrique du module solaire et/ou le module de communication de données local (25) peut/peuvent être embroché(s) sur la platine de base (8a) et/ou sur la platine auxiliaire (8b).
